# EUROPEAN PATENT APPLICATION

(11) **EP 0 709 718 A2**
(43) Date of publication of application: **01.05.1996**
(21) Application number: 95116750.1
(22) Date of filing: 24.10.1995
(51) Int. Cl.: G02F 1/136, H01L 27/12

(54) **Liquid crystal display apparatus and production method thereof**

(30) Priority: 28.10.1994 JP 264841/94
(71) Applicant: HITACHI, LTD., Chiyoda-ku, Tokyo 101 (JP)
(72) Inventor: Kawachi, Genshiro, Hitachi-shi, Ibaraki 316 (JP); Sato, Tsutomu, Mobara-shi, Chiba 297 (JP); Ogawa, Kazuhiro, Mobara-shi, Chiba 297 (JP); Anno, Kouichi, Mobara-shi, Chiba 297 (JP); Wakui, Yoko, Naka-gun, Ibaraki 319-11 (JP); Asuma, Hiroaki, Mobara-shi, Chiba 297 (JP); Ishii, Masahiro, Mobara-shi, Chiba 297 (JP)
(74) Representative: Patentanwälte Beetz - Timpe - Siegfried Schmitt-Fumian - Mayr

(57) **Abstract**

The invention relates to a liquid crystal display apparatus comprising a plurality of scanning electrodes (10), a plurality of image data electrodes (14) intersecting the scanning electrodes (10) in a matrix structure and forming a plurality of pixels, an active matrix substrate (1) carrying thin film transistors (TFTs) connected to the vicinities of the intersections of the scanning electrodes (10) and the image data electrodes (14), and pixel electrodes (13) connected to the thin film transistors, a countersubstrate (508) opposite to the active matrix substrate (1), and a liquid crystal layer (506) provided between the active matrix substrate (1) and the countersubstrate (508), the display apparatus further comprising:
additional capacitors, each thereof being formed by a pixel electrode (13), a scanning electrode (10), neighboring one of the scanning electrodes (10) connected to one of the thin film transistors, in each of the plurality of pixels, and an insulation film (20) formed on the neighboring scanning electrode (10),
and
a semiconductor film (30) and a gate insulation film (21) composing each of the thin film transistors, the semiconductor film (30) and the gate insulation film (21) having almost or essentially the same plan shape.

## Description

### BACKGROUND OF THE INVENTION

The present invention relates to a liquid crystal display apparatus of active matrix type using thin film semiconductors, which may be applied to apparatus for displaying image information and character information such as OA (Office Automation) apparatus.

In a conventional liquid crystal display apparatus, an additional capacitor is generally provided in parallel to the liquid crystal capacitor to improve the picture quality, by preventing a decrease of the liquid crystal driving voltage caused by a leak current of the thin film transistors (TFT) and a resistance decrease of the liquid crystal material due to contamination, and superposition of a direct current component on the liquid crystal driving signal caused by the field-through voltage due to the parasitic capacitance between the gate and the source of the TFT. Various kinds of structures for composing an additional capacitor have been disclosed. For example, as the first conventional technique, a capacitance having two insulation layers made by a tantalum oxide (Ta₂O₅) layer and a silicon nitride (SiN) layer is disclosed in JP-A-137826/1990.

Further, shortening the production process of a TFT substrate is effective to reduce the production cost. For example, as the second conventional technique, a method for reducing the number of steps of the production process by processing semiconductor layers comprising TFTs and SiN films composing gate insulation films with the same photo-mask, which reduces the number of steps of the photo-etching process, is disclosed in JP-A-228632/1990. The essential feature of this technique is that the dielectric layer of the additional capacitor is composed of two layers, i.e. a semiconductor layer and a SiN film.

### SUMMARY OF THE INVENTION

The first conventional technique requires a long production process since the photo-etching process of SiN films and that of semiconductor films are to be carried out with different photo-masks, to leave a pattern of semiconductor layers at the parts of the TFTs and to remove semiconductor films at the parts of the additional capacitors.

Further, if additional capacitors composed of SiN films and semiconductor films, according to the second conventional technique, are used to reduce the step number of the production process, a good display performance cannot be obtained since the voltage applied to the liquid crystal is attenuated during the image keeping period in driving a pixel, and a charge keeping effect, which is the primary object of the additional capacitor, cannot be obtained.

Therefore, the present invention aims at providing a liquid crystal display apparatus which can be made by a short production process and can have a good picture quality.

The above problem is solved according to the independent claims. The dependent claims relate to preferred embodiments.

The liquid crystal display apparatus of the present invention comprises a plurality of scanning electrodes, a plurality of image data electrodes intersecting the scanning electrodes in a matrix structure and forming a plurality of pixels, an active matrix substrate comprising thin film transistors (TFTs) connected to the vicinities of the intersections of the scanning electrodes and the image data electrodes, and pixel electrodes connected to the thin film transistors, a countersubstrate opposite to the active matrix substrate, and a liquid crystal layer provided between the active matrix substrate and the counter-substrate; the display apparatus further comprises:
additional capacitors, each being formed by a pixel electrodes, another one of the scanning electrodes, neighboring one of the scanning electrodes connected to one of the thin film transistors, in each of the plurality of pixels, and an insulation film formed on the neighboring scanning electrode and
a semiconductor film and a gate insulation film composing each of the thin film transistors, the former two films having almost or essentially the same plan shape.

By the above-mentioned structure of the display apparatus, the step number of the production process can be reduced since the both films can be processed with the same photo-mask by making the semiconductor film and the gate insulation film composing the thin film transistors such that they have almost the same plan shape.

Further, a good picture quality can be also obtained since the formation of a capacitor including two layers, i.e., a semiconductor layer and an insulation film, is avoided by providing each of the capacitors formed by each of the pixel electrodes, one of the scanning electrodes neighboring one of the scanning electrodes connected to one of the thin film transistors in each of the plurality of pixels and an insulation film formed on the one of the scanning electrodes. Furthermore, since the interface of the pixel electrode and the insulation film is not exposed to chemicals in the production process, a degradation of the insulation withstanding voltage can be prevented.

In the present invention, the additional capacitors can be also formed by providing common electrodes on the same substrate as the scanning electrodes are provided, and forming an insulation film so as to cover each of the common electrodes and forming each of the pixel electrodes on the insulation film. By this structure, a good picture quality can be obtained even in a large screen or in a screen of high definition since the load capacitance of the scanning electrodes can be decreased, and the propagation delay of the scanning signals can be reduced.

According to a preferred embodiment of the present invention, the side surfaces of the scanning electrode pattern and/or the common electrode pattern are processed in a tapered shape. By the tapered shape, it can be prevented that the pixel electrodes are broken at the different level parts of the side surfaces of the scanning electrode pattern or the common electrode pattern. Further, a high insulation withstanding voltage is secured since a field concentration at the corner of the electrode pattern can be avoided.

According to another preferred embodiment, the scanning electrodes and/or the common electrodes are composed by a compound layer laminated by two or more layers as which metal films of metals of the group of Al, Ta, Ti, Nb, Zr, V and Hf, alloy films of the metals of this group or nitride alloy films of metals of this group are used. By using such materials for the compound layer composing the electrodes, the insulation withstanding voltage is further improved since a self-oxidized film having good insulation characteristics is formed. Especially, if the scanning electrodes and the common electrodes are made of an alloy whose main component is Al, since the resistances of the scanning electrodes and the common electrodes are reduced, the propagation delay of scanning signals can be decreased, which makes it easier to realize large screens and screens of high definition. Further, since an alumina film formed by a self-oxidized film of Al is a very stable material which cannot be etched by usual etching gases or chemicals for semiconductor processing, a good production yield is attained. And, since the interface between the pixel electrode and the insulation film is not exposed to chemicals in the processing by adopting a production processing including the steps of forming the scanning electrodes on the substrate, of forming the insulation oxide films coating the scanning electrodes and of forming the pixel electrodes, a degradation of the insulation withstanding voltage can be prevented.

### BRIEF DESCRIPTION OF THE DRAWINGS

These and other objects, features and advantages of the present invention will be understood more clearly from the following detailed description with reference to the accompanying drawings, wherein
- Fig. 1: is a cross-sectional view of a unit pixel in an embodiment of a liquid crystal display apparatus of the present invention;
- Fig. 2: is a cross-sectional view of a unit pixel in another embodiment of a liquid crystal display apparatus of the present invention;
- Fig. 3: is a plan view of the unit pixel shown in Fig. 2;
- Fig. 4: is a cross-sectional view of a unit pixel in a further embodiment of a liquid crystal display apparatus of the present invention;
- Fig. 5: is a plan view of the unit pixel shown in Fig. 4;
- Fig. 6: is a cross-sectional view of a unit pixel in a further embodiment of a liquid crystal display apparatus of the present invention;
- Fig. 7: is a plan view of the unit pixel shown in Fig. 6;
- Fig. 8: is a cross-sectional view of a unit pixel in a further embodiment of a liquid crystal display apparatus of the present invention;
- Fig. 9: is a plan view of the unit pixel shown in Fig. 8;
- Figs. 10-15: are pictures for explaining steps of the production process of the embodiment shown in Figs. 6 and 7;
- Fig. 16: shows the relation between the insulation withstanding voltage of a self-oxidized film and the total content of the sum weight of Ti and Ta in Al alloy;
- Fig. 17: is a cross-sectional view of an example of the liquid crystal display apparatus of the present invention;
- Fig. 18: is a picture showing an example for the arrangement of pixels in a liquid crystal display apparatus of the present invention; and
- Fig. 19: is an equivalent circuit diagram of the whole liquid crystal display apparatus of the present invention.

### DETAILED DESCRIPTION OF THE EMBODIMENTS

Hereinafter, details of the present invention will be explained based on embodiments referring to the drawings.

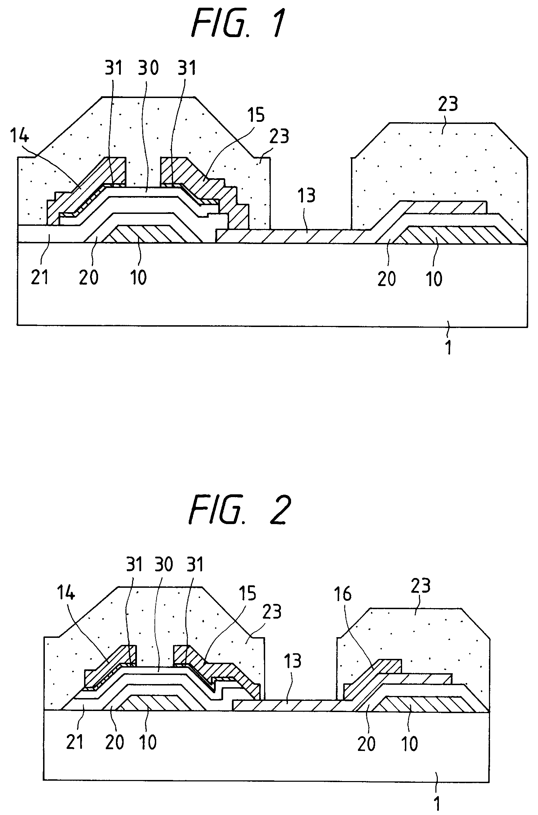

Fig. 1 shows a cross-sectional view of a unit pixel of an embodiment of the present invention. A scanning electrode 10 made of Al is formed on a glass substrate 1, and the surface of the electrode 10 is coated with an alumina film 20. The terminal parts of the pattern of the scanning electrode are processed in a tapered shape. On the alumina film 20, a TFT including a gate insulation film 21 made by a SiN film, a non-crystalline Si (a-Si) film 30, an n-type a-Si film 31, an image data electrode 14 and a source electrode 15 is formed. On the glass substrate 1, a pixel electrode 13 made of an indium-tin oxide (ITO) film is formed and one terminal side of the pixel electrode 13 is connected to the source electrode 15. The other terminal side of the pixel electrode 13 goes over the neighboring scanning electrode 10, on the surface of which an alumina film 20 is formed, and forms an additional capacitor. Then, a protective insulation film 23 made of a SiN film is formed so as to cover the TFT and the additional capacitor.

The characteristic feature of the embodiment is that the pixel electrode 13 and the scanning electrode 10 are formed on the same plane, and the additional capacitor is formed by the terminal side of the pixel electrode 13 going over the neighboring scanning electrode 10. Since the formation of a capacitor including two layers, i.e. a semiconductor layer and an insulation layer, can be avoided by the above-mentioned structure, an attenuation of the voltage applied to the liquid crystal can be prevented during the image keeping period, which leads to good image keeping characteristics. Further, good insulation characteristics can be realized since the alumina film 20 composing the additional capacitor is covered by the pixel electrode 13 and not exposed to an etching liquid or gas in the production process of the source electrode 15, the image data electrode 14 or the gate insulation film 21. And another feature is that the breaking of the pixel electrode 13 in the region of different level relative to the neighboring scanning electrode 10 can be prevented since the side faces of the scanning electrode 10 are processed in a tapered shape. Furthermore, since a field concentration at the pattern edges is prevented, the insulation characteristics are improved.

Fig. 2 shows a cross-sectional view of a unit pixel of another embodiment of the present invention. The characteristic feature of the embodiment is that the a-Si film 30 and the gate insulation film 21 are processed so as to have almost the same plan shape, and a protective electrode 16 is formed over the pixel electrode 13 in the region of different level relative to the neighboring scanning electrode 10. Therefore, the production process is shortened since the a-Si film 30 and the gate insulation film 21 can be processed by one step of a photo-etching process by making the two films so as to have almost the same plan shape. Further, the production yield of liquid crystal display apparatus is improved since the possibility of breaking of the pixel electrodes at the parts of different levels can be decreased by forming the protective electrode 16 over the pixel electrode 13 in the region of different level relative to the neighboring scanning electrode 10.

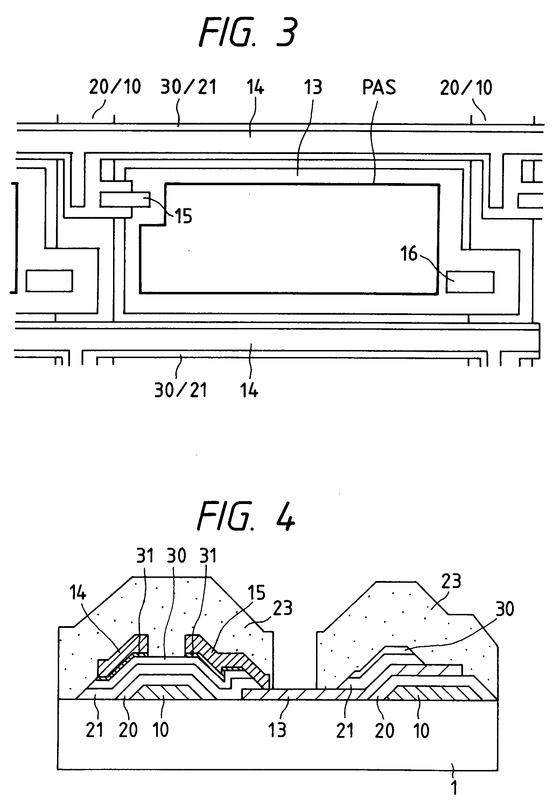

Fig. 3 shows a plan view of a unit pixel of the embodiment shown in Fig. 2. The pattern of the a-Si film 30 and the gate insulation film 21 is formed not only at the TFT but also along the image data electrode 14. Then, the breaking of the image data electrode at the part of different level can be prevented since the bad effects of the level difference of the scanning electrode are avoided by the above-mentioned structure. Further, a liquid crystal display apparatus of little light reflection and clear visibility can be achieved since the light reflection from the back face of the image data electrode 14 can be weakened by an a-Si film 30 having good absorption characteristics to visible light.

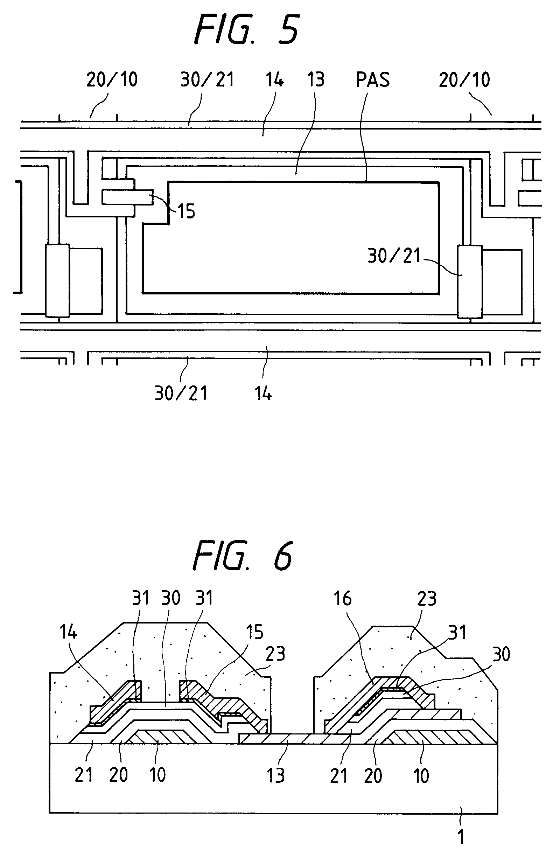

Figs. 4 and 5 show a cross-sectional view and a plan view of a unit pixel of a further embodiment of the present invention, respectively. The characteristic feature of the embodiment is that the pattern of the a-Si film 30 and the gate insulation film 21 is formed at the different level part of the scanning electrode 10 in the additional capacitor part. If an ITO electrode used for the pixel electrode is formed at this different level part, cracks may occur in the electrode in a wedge shape from the edge part of the pattern at the different level part. If the cracked part is exposed to etching gas or liquid in the later process, the etching gas or liquid enters into the interface between the pixel electrode 13 and the alumina film 20 from the cracked part and deteriorates the insulation characteristics. Then, since the entering of etching gas or liquid can be prevented by protecting the part different in level by the gate insulation film 21 in accordance with this embodiment, the production yield is improved.

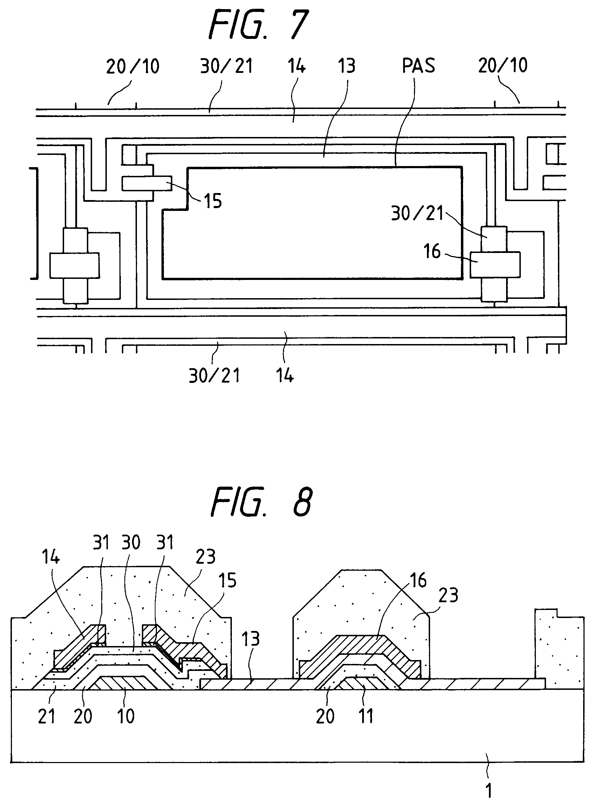

Figs. 6 and 7 show a cross-sectional view and a plan view of a unit pixel of a further embodiment of the present invention, respectively. The characteristic feature of this embodiment is that the pattern of the a-Si film 30, the n-type a-Si film 31 and the gate insulation film 21 is formed at the part different in level of the scanning electrode in the additional capacitor part, and the protective electrode 16 is formed so as to go over the pattern of the a-Si film 30, the n-type a-Si film 31 and the gate insulation film 21. Then, the entering of etching gas or liquid can be prevented by protecting the different level part by the gate insulation film 21, in this embodiment as well as in the embodiment shown in Figs. 4 and 5.

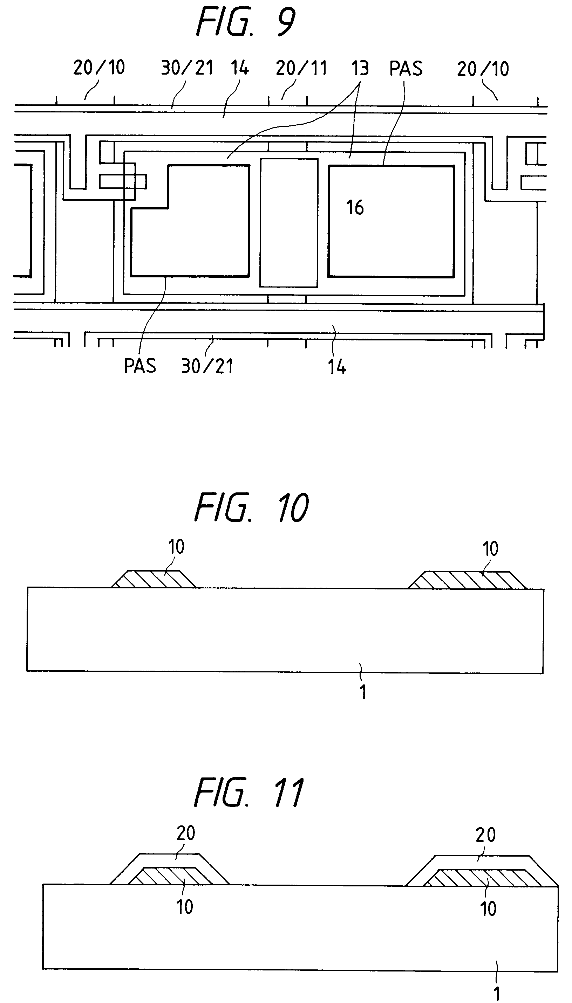

Figs. 8 and 9 show a cross-sectional view and a plan view of a unit pixel of a further embodiment of the present invention, respectively. On the glas substrate 1, the pixel electrode 13 made by the indium-tin oxide (ITO) film is formed, and one terminal side of the pixel electrode 13 is connected to the source electrode 15, and the other terminal side of the pixel electrode 13 goes over the neighboring common electrode 11, on the surface of which the alumina film 20 is formed, and forms the additional capacitor. Also by this embodiment, a good picture quality can be obtained even in a large screen or in a screen of high definition since the load capacitance of the scanning electrodes can be decreased by forming the common electrodes separated from the scanning electrodes, and the propagation delay of the scanning signals can be reduced.

Next, the production process of the TFT substrate of the present invention is explained by referring to Figs. 10-15.

At first, as shown by Fig. 10, an Al film of e.g. 300 nm is laminated on a glass substrate 1 by sputtering, and scanning electrodes 10 are formed by patterning the Al film in the predetermined shape by photo-lithography.

Next, as shown by Fig. 11, an alumina film 20 is formed on each of the scanning electrodes by anodic oxidation. The anodization is carried out in a solution obtained by diluting a solution of tartaric acid with ethylene glycol, whose pH is adjusted to about 7 by using aqueous ammonia. By this method, an alumina film of about 200 nm is obtained at a voltage of 145 V.

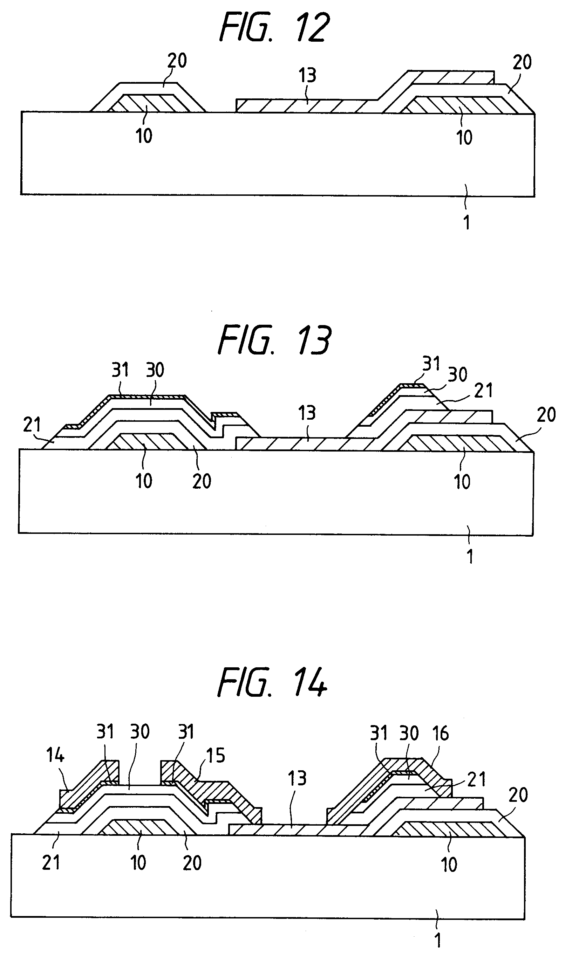

Then, as shown by Fig. 12, an ITO film of e.g. 120 nm is laminated on the glass substrate 1 by sputtering, and the pixel electrodes 13 are formed by patterning the ITO film into the predetermined shape. The pixel electrodes are formed so as to go over a part of a neighboring scanning electrodes, on the surface of which an alumina film is formed. The above-mentioned part is used to make an additional capacitor. Then, since the alumina film of the additional capacitor is not exposed to etching gas or liquid in the later process, by forming an upper electrode of the additional capacitor very after the formation of the alumina film, a good insulation withstanding voltage can be achieved.

Then, as shown by Fig. 13, an SiN film 21 for a gate insulation film of the TFT, an intrinsic non-crystalline Si film 30 and an n-type non-crystalline Si film 31 are successively formed. The SiN film of a thickness of e.g. 200 nm is formed by using SiH₄, H₂ and NH₃ as material gas at a substrate temperature of 300 °C. The intrinsic Si film of a thickness of e.g. 250 nm is formed by using SiH₄ as material gas at a substrate temperature of 250 °C. The n-type intrinsic Si film of e.g. 50 nm in thickness is formed by using SiH₄ and pH 3 as material gas at a substrate temperature of 250 °C. Then, it is preferable that the potential of the scanning electrode 10 is set to the earth potential. By setting the potential so, a dielectric breakdown of the alumina film in the process can be prevented since the charge-up effect is avoided in the CVD processing even if charged particles in the plasma are injected into the substrate. The scanning electrode easily charges up the charged particles since it is formed in a wide area. Therefore, a dielectric breakdown of the formed capacitor is easily caused if the above-mentioned counter-action of the potential setting is not done, since the formed capacitor has a small capacitance of less than 1 pF. Successively, the SiN film 21, the intrinsic non-crystalline Si film 30 and the n-type intrinsic non-crystalline Si film 31 are patterned in almost the same plan shape by using the same photo-mask. For etching, SF₆ gas is used. Then, the shape of the whole etched films becomes tapered since the etching speed of the intrinsic non-crystalline Si 30 film and the n-type intrinsic Si film 31 is larger than that of the SiN film 21, in the etching process with SF₆ gas. The tapered shape of the films is effective for preventing the later-formed upper electrode from breaking at the parts of different level. Further, by forming the intrinsic non-crystalline Si 30 film, the n-type intrinsic Si film 31 and the SiN film 21 at the different level parts of the scanning electrodes in the additional capacitors, a good insulation withstanding voltage can be achieved since the alumina film of the capacitor part is prevented from being exposed to etching gas or liquid in the later process.

Then, as shown by Fig. 14, a Cr film of e.g. 50 nm and an Al film of e.g. 400 nm are laminated on the glass substrate 1 by sputtering, and image data electrodes 14, source electrodes 15 and protective electrodes 16 of the additional capacitors are formed by patterning the films in the predetermined shapes.

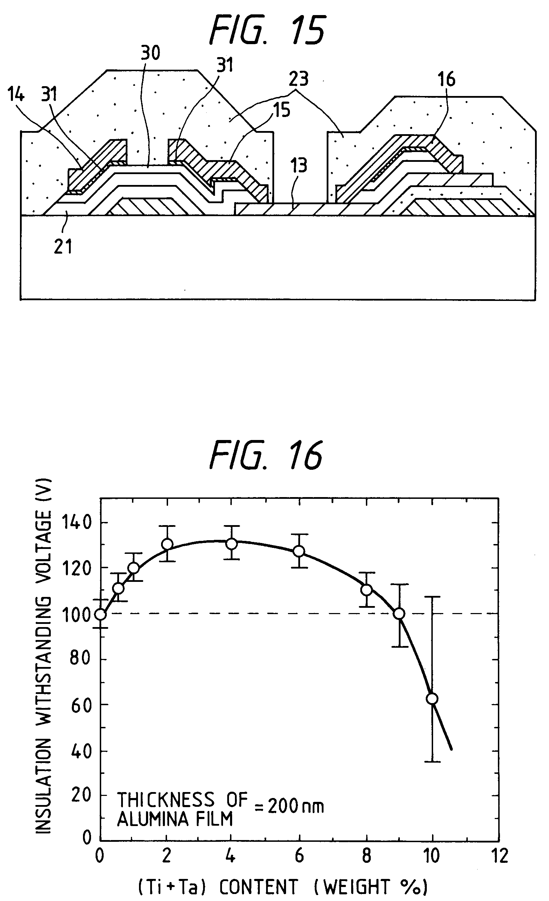

Finally, as shown by Fig. 15, the TFT is completed by forming a protective SiN film 23 covering the TFT part and the additional capacitor part. In the above-mentioned embodiment, Al is used for the scanning electrode 10 and the common electrode 12, and an alumina film obtained by self-oxidization of the Al film is utilized for the dielectric of the additional capacitor. However, the material for forming the electrodes is not restricted to Al, and materials whose self-oxidized films have good insulation characteristics, such as Ta, Ti, Nb, V, Hf and so forth, are also applicable. The nitrids of the above-mentioned metals are preferable since the leak current can be reduced thereby.

From the view point of improving the insulation withstanding voltage, it is especially preferable, in the case of using an alloy whose main component is Al, to use an alloy where the sum of Ti and Ta is 0.8-8.5 weight % in the alloy. Fig. 16 shows the relation between the insulation withstanding voltage and the content of the sum amount of Ti plus Ta in the Al alloy. The insulation withstanding voltage degrades if the content is outside the above-mentioned range. Fig. 16 shows that a good insulation withstanding voltage can be obtained by using an Al alloy containing a sum amount of Ti and Ta within the range of 0.8-8.5 weight %.

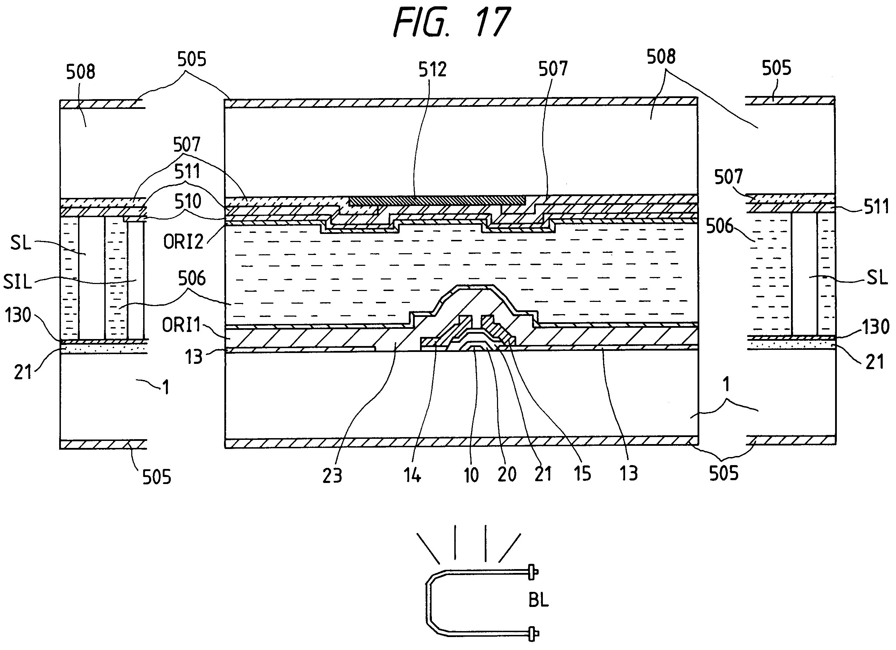

Fig. 17 shows a typical cross-sectional view of an example of the liquid crystal display apparatus of the present invention. On the substrate 1 at the lower side shown in the figure, the scanning electrodes 10 and the image data electrodes 14 are formed in a matrix structure, and each pair of those electrodes drives each of the pixel electrodes 13 via a TFT formed at the vicinity of each intersection in the matrix of the electrodes. And, on a substrate 508 subtending the substrate 1 via a liquid crystal layer 506, a counterelectrode 510 made of ITO, a color filter 507, a protective film for the color filter 511 and a shade film 512 forming a shading black matrix pattern are formed. The central part of Fig. 17 shows a cross-sectional view of one pixel region. The left part of the figure shows a cross-sectional view of the left terminal side part of the pair of substrates 1 and 508, in which an outgoing lead terminal is provided, and the right part of the figure a cross-sectional view of the right terminal side part not including the outgoing lead terminal. The symbol SL marked at the left and right sides indicates a seal which is composed so as to seal the liquid crystal layer and formed along the whole edge of the substrates 1 and 508 with the exception of a liquid crystal charging entrance (not shown in the figure). Then, a seal material, for example, epoxy resins are used. The counter-electrode 510 on the glass countersubstrate 508 is connected to an outgoing wiring 130 formed by using silver paste SIL on the glass substrate 1, at least one point. The outgoing wiring 130 is formed in the same production process step as the scanning electrodes 10, the source electrodes 15 and the image date electrodes 14. Orientation films ORI1 and ORI2, the pixel electrodes 13, the protection film 23, the protective film for color filter 511 and the gate SiN films 21 are formed inside the seals SL. A polarizing plate is formed on the outer surfaces of the glass substrates 1 and 508.

The liquid crystal layer 506 is enclosed between the lower orientation film ORI1 and the upper orientation film ORI2 which orient the molecules of the liquid crystal, and sealed by the seals SL. The lower orientation film ORI1 is formed on the protective film 23 at the side of the glass substrate 1. On the inside surface of the glass countersubstrate, the shade film 510, the color filter 507, the protective film for color filter 511, the counterelectrode 510 and the upper orientation film ORI2 are successively laminated. The layers on the glass substrate 1 and the layers on the glass countersubstrate 508 are made independently. Then, by superposing the upper glass substrate 508 on the lower glass substrate 1 and enclosing the liquid crystal 506 between the substrates, the liquid crystal display apparatus is composed. By the above-mentioned structure, a TFT driven type color liquid crystal display apparatus is realized, in which the transmission of light from a back light BL is adjusted by the pixel electrodes 13.

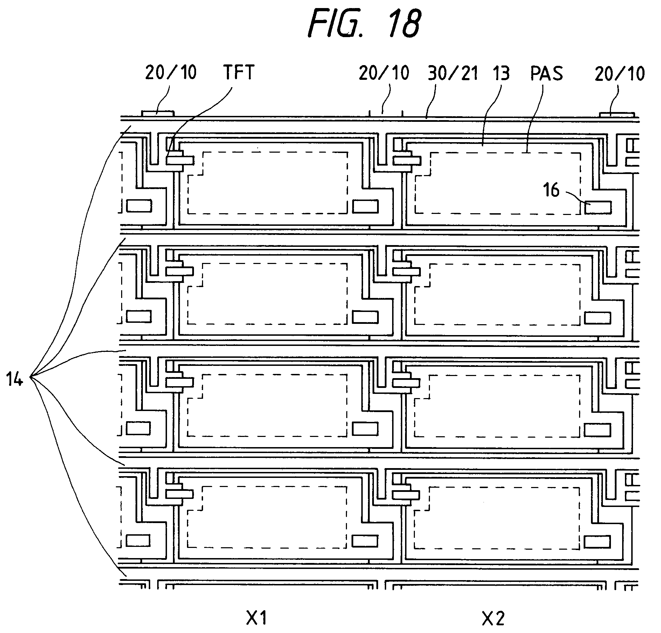

Fig. 18 shows a plan view of the pixel arrangement on the TFT substrate. A plurality of pixels are arranged in the scanning electrode extending direction, and compose the pixel columns X1, X2, ...., . In each pixel of the pixel columns X1, X2, .... , the TFT, the pixel electrode 13 and the additional capacitor 16 are positioned at the same places. The image data electrodes 14 are arranged so as to intersect one of the scanning electrodes 10, and connected to one pixel electrode in each pixel column via the TFT.

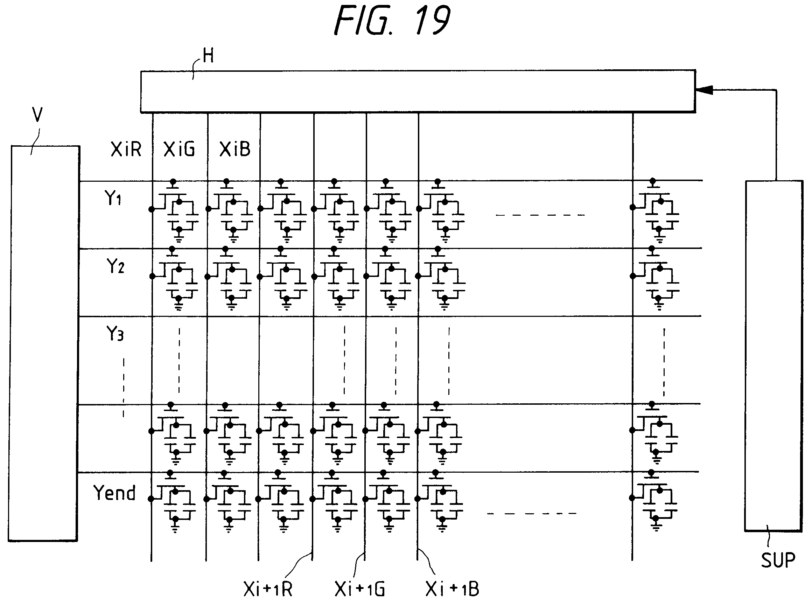

Fig. 19 shows an equivalent circuit of the whole display apparatus. XiG, Xi+1G, .... are the image data electrodes connected to the pixels at which a green filter G is formed. Similarly, XiB, Xi+1B, .... are the image data electrodes connected to the pixels at which a blue filter G is formed, and XiR, Xi+1R, .... are the image data electrodes connected to the pixels at which a red filter R is formed. Yi, Yi+1, .... are the scanning electrodes 10 for selecting the pixel columns X1, X2, .... and connected to a vertically scanning circuit V. The image data electrodes are connected to an image data signal drive circuit H. A power source circuit SUP is a circuit including a source circuit for obtaining stable voltage sources by dividing a source voltage and a circuit for converting information from a host apparatus (an upper information processing apparatus) for a cathode ray tube to information for a liquid crystal display panel.

## Claims

1. Liquid crystal display apparatus comprising a plurality of scanning electrodes (10), a plurality of image data electrodes (14) intersecting the scanning electrodes (10) in a matrix structure and forming a plurality of pixels, an active matrix substrate (1) carrying thin film transistors (TFTs) connected to the vicinities of the intersections of the scanning electrodes (10) and the image data electrodes (14), and pixel electrodes (13) connected to the thin film transistors, a countersubstrate (508) opposite to the active matrix substrate (1), and a liquid crystal layer (506) provided between the active matrix substrate (1) and the countersubstrate (508), the display apparatus further comprising:
additional capacitors, each thereof being formed by a pixel electrode (13), a scanning electrode (10), neighboring one of the scanning electrodes (10) connected to one of the thin film transistors, in each of the plurality of pixels, and an insulation film (20) formed on the neighboring scanning electrode (10), and
a semiconductor film (30) and a gate insulation film (21) composing each of the thin film transistors, the semiconductor film (30) and the gate insulation film (21) having almost or essentially the same plan shape.

2. Liquid crystal display apparatus comprising a plurality of scanning electrodes (10), a plurality of image data electrodes (14) intersecting the scanning electrodes (10) in a matrix structure and forming a plurality of pixels, a plurality of common electrodes (12) provided among the plurality of scanning electrodes (10) in the plurality of pixels, an active matrix substrate (1) carrying thin film transistors (TFTs) connected to the vicinities of the intersections of the scanning electrodes (10) and the image data electrodes (14), and pixel electrodes (13) connected to the thin film transistors, a countersubstrate (508) opposite to the active matrix substrate (1), and a liquid crystal layer (506) provided between the active matrix substrate (1) and the countersubstrate (508), the display apparatus further comprising:
additional capacitors, each thereof being formed by each a pixel electrode (13), one of the common electrodes (12), and an insulation film (20) formed on the respective common electrode (12), and
a semiconductor film (30) and a gate insulation film (21) composing each of the thin film transistors, the semiconductor film (30) and the gate insulation film (21) having almost or essentially the same plan shape.

3. Liquid crystal display apparatus according to claim 1 or 2, wherein the insulation films (20) are self-oxidized films formed by oxidizing the scanning electrodes (10).

4. Liquid crystal display apparatus according to any of claims 1 to 3, wherein each pattern of the semiconductor films (30) and each of the gate insulation films (21) are formed under each of the thin film transistors and each of the image data electrodes (14).

5. Liquid crystal display apparatus according to any of claims 1 to 4, wherein the side faces of the scanning electrodes (10) are processed in a tapered shape.

6. Liquid crystal display apparatus according to any of claims 1 to 5, wherein the scanning electrodes (10) are made of a metal film of a metal of the group of metals of Al, Ta, Ti, Zr, V and Hf, an alloy film of metals of this group or a nitride alloy film of metals of this group.

7. Liquid crystal display apparatus according to any of claims 2 to 6, wherein the common electrodes (12) are made of a metal film of a metal of the group of metals of Al, Ta, Ti, Zr, V and Hf, an alloy film of metals of this group or a nitride alloy film of metals of this group.

8. Liquid crystal display apparatus according to any of claims 1 to 7, wherein the scanning electrodes (10) are made of an alloy comprising Al as a main component and containing Ti and Ta, the sum of Ti and Ta being 0.8-8.5 weight % of the alloy.

9. Liquid crystal display apparatus according to any of claims 2 to 8, wherein the common electrodes (12) are made of an alloy comprising Al as a main component and containing Ti and Ta, the sum of Ti and Ta being 0.8-8.5 weight % of the alloy.

10. Liquid crystal display apparatus according to any of claims 1 to 9, wherein a part of the pixel electrodes (13), being superimposed on the insulation films (20), is covered by the gate insulation film (21).

11. Method for producing liquid crystal display apparatus, particularly those according to claims 1 to 10, comprising the following steps:
(A) forming scanning electrodes (10) on a substrate (1),
(B) forming an insulation film (20) so as to cover the scanning electrodes (10), and
(C) forming pixel electrodes (13) on the insulation film (20).

12. Method according to claim 11, further comprising the following steps:
(D) laminating gate insulation films (21) and semiconductor films (30) on the substrates (1), and
(E) processing the gate insulation films (21) and the semiconductor films (30) in almost or essentially the same plan shape.
